(19) Europäisches Patentamt / European Patent Office / Office européen des brevets

(11) **EP 2 326 013 B1**

(12) **EUROPÄISCHE PATENTSCHRIFT**

(45) Veröffentlichungstag und Bekanntmachung des Hinweises auf die Patenterteilung:
**06.11.2013  Patentblatt 2013/45**

(51) Int Cl.:
***H04N 7/26*** (2006.01)

(21) Anmeldenummer: **10185209.3**

(22) Anmeldetag: **02.05.2003**

(54) **Verfahren und Anordnung zur arithmetischen Enkodierung und Dekodierung mit Verwendung mehrerer Tabellen**

Method and arrangement for arithmetic encoding and decoding with use of a plurality of look-up tables

Procédé et agencement d'encodage et de décodage arithmétiques utilisant une pluralité de tables de consultation

(84) Benannte Vertragsstaaten:
**AT BE BG CH CY CZ DE DK EE ES FI FR GB GR HU IE IT LI LU MC NL PT RO SE SI SK TR**

(30) Priorität: **02.05.2002  DE 10220962**

(43) Veröffentlichungstag der Anmeldung:
**25.05.2011  Patentblatt 2011/21**

(62) Dokumentnummer(n) der früheren Anmeldung(en) nach Art. 76 EPÜ:
**08020010.8 / 2 037 412**
**03725141.0 / 1 550 219**

(73) Patentinhaber: **Fraunhofer-Gesellschaft zur Förderung der Angewandten Forschung e.V.**
**80686 München (DE)**

(72) Erfinder:
- **Marpe, Detlev**
  **12161, Berlin (DE)**
- **Wiegand, Thomas**
  **14195, Berlin (DE)**

(74) Vertreter: **Schenk, Markus et al**
**Schoppe, Zimmermann, Stöckeler & Zinkler Patentanwälte**
**Postfach 246**
**82043 Pullach bei München (DE)**

(56) Entgegenhaltungen:
**US-A- 5 592 162**

- **PRINTZ H ET AL: "Multialphabet arithmetic coding at 16 MBytes/sec", DATA COMPRESSION CONFERENCE, 1993. DCC '93. SNOWBIRD, UT, USA 30 MARCH-2 APRIL 1993, LOS ALAMITOS, CA, USA,IEEE COMPUT. SOC, US, 30. März 1993 (1993-03-30), Seiten 128-137, XP010031839, DOI: 10.1109/DCC.1993.253137 ISBN: 978-0-8186-3392-8**
- **D.S. TAUBMAN, M.W. MARCELLIN: "JPEG2000: image compression fundamentals, standards and practice", 2002, KLUWER ACADEMIC PUBLISHERS, XP002566993, * Kapitel 2.3.5; Tabelle 2.1 ***
- **CHEVION D ET AL: "High efficiency, multiplication free approximation of arithmetic coding", 8. April 1991 (1991-04-08), DATA COMPRESSION CONFERENCE, 1991. DCC '91. SNOWBIRD, UT, USA 8-11 APRIL 1991, LOS ALAMITOS, CA, USA,IEEE COMPUT. SOC, US, PAGE(S) 43 - 52, XP010034259, ISBN: 978-0-8186-9202-4 * Seite 47, Absatz 1 ***
- **"TEXT OF FINAL COMMITTEE DRAFT OF JOINT VIDEO SPECIFICATION (ITU-T REC. H.264 / ISO/IEC 14496-10 AVC), 9.2. CABAC", INTERNATIONAL ORGANIZATION FOR STANDARDIZATION - ORGANISATIONINTERNATIONALE DE NORMALISATION, XX, XX, 1. Juli 2002 (2002-07-01), Seiten 103-114, XP002336525,**
- **MARPE D ET AL: "Context-based adaptive binary arithmetic coding in JVT/H.26L", INTERNATIONAL CONFERENCE ON IMAGE PROCESSING (ICIP),, Bd. 2, 22. September 2002 (2002-09-22), Seiten 513-516, XP010608021, ISBN: 978-0-7803-7622-9**

**Beschreibung**

Die Erfindung betrifft ein Verfahren und eine Anordnung zur arithmetischen Enkodierung und Dekodierung von binären Zuständen sowie ein entsprechendes Computerprogramm und ein entsprechendes computerlesbares Speichermedium, welche insbesondere bei der digitalen Datenkompression eingesetzt werden können.

Die vorliegende Erfindung beschreibt ein neues effizientes Verfahren zur binären arithmetischen Kodierung. Der Bedarf nach binärer arithmetischer Kodierung entsteht in den verschiedensten Anwendungsbereichen der digitalen Datenkompression; hier sind vor allem Anwendungen in den Bereichen der digitalen Bildkompression von beispielhaften Interesse. In zahlreichen Standards zur Bildkodierung, wie etwa JPEG, JPEG-2000, JPEG-LS und JBIG wurden Verfahren zur binären arithmetischen Kodierung definiert. Neuere Standardisierungsaktivitäten lassen auch den zukünftigen Einsatz derartiger Kodiertechniken im Bereich der Videokodierung (CABAC in H.264/AVC) erkennen [1].

Die Vorteile der arithmetischen Kodierung (AK) gegenüber der bisher in der Praxis häufig verwendeten Huffman-Kodierung [2] lassen sich im wesentlichen durch drei Merkmale charakterisieren:

1. Mit der Verwendung der arithmetischen Kodierung lässt sich durch einfache Adaptionsmechanismen eine dynamische Anpassung an die vorhandene Quellenstatistik erzielen (Adaptivität).

2. Die arithmetische Kodierung erlaubt die Zuweisung von einer nicht ganzzahligen Anzahl von Bits pro zu kodierendem Symbol und ist damit geeignet, Kodierresultate zu erzielen, die eine Approximation der Entropie als der theoretisch gegebenen unteren Schranke darstellen (Entropie-Approximation) [3].

3. Unter Zuhilfenahme geeigneter Kontextmodelle lassen sich mit der arithmetischen Kodierung statistische Bindungen zwischen Symbolen zur weiteren Datenreduktion ausnutzen (Intersymbol-Redundanz) [4].

Als Nachteil einer Anwendung der arithmetischen Kodierung wird der im Vergleich zur Huffman-Kodierung i. a. erhöhte Rechenaufwand angesehen.

Das Konzept der arithmetischen Kodierung geht zurück auf die grundlegenden Arbeiten zur Informationstheorie von Shannon [5]. Erste konzeptionelle Konstruktionsmethoden wurden in [6] erstmals von Elias veröffentlicht. Eine erste LIFO (last-in-first-out) Variante der arithmetischen Kodierung wurde von Rissanen [7] entworfen und später von verschiedenen Autoren zu FIFO-Ausbildungen (first-in-first-out) modifiziert [8][9][10].

Gemeinsam ist allen diesen Arbeiten das zugrundeliegende Prinzip der rekursiven Teilintervallzerlegung: Entsprechend den gegebenen Wahrscheinlichkeiten $P("0")$ und $P("1")$ zweier Ereignisse {"0", "1"} eines binären Alphabets wird ein anfänglich gegebenes Intervall, z.B. das Intervall [0, 1), je nach Auftreten von Einzelereignissen rekursiv in Teilintervalle zerlegt. Dabei ist die Größe des resultierenden Teilintervalls als Produkt der Einzelwahrscheinlichkeiten der aufgetretenen Ereignisse proportional zur Wahrscheinlichkeit der Folge der Einzelereignisse. Da jedes Ereignis $S_i$ mit der Wahrscheinlichkeit $P(S_i)$ einen Beitrag von $H(S_i) = -log(P(S_i))$ des theoretischen Informationsgehalts $H(S_i)$ von $S_i$ zur Gesamtrate beiträgt, ergibt sich eine Beziehung zwischen der Anzahl $N_{Bit}$ der Bits zur Darstellung des Teilintervalls und der Entropie der Folge von Einzelereignissen, die durch die rechte Seite der folgenden Gleichung angegeben ist

$$N_{Bit} = -\log \prod_i P(S_i) = -\sum_i \log P(S_i) \quad .$$

Das Grundprinzip erfordert jedoch zunächst eine (theoretisch) unbegrenzte Genauigkeit in der Darstellung des resultierenden Teilintervalls und hat darüber hinaus den Nachteil, dass erst nach Kodierung des letzten Ereignisses die Bits zur Repräsentierung des resultierenden Teilintervalls ausgegeben werden können. Für praktische Anwendungszwecke war es daher entscheidend, Mechanismen für eine inkrementelle Ausgabe von Bits bei gleichzeitiger Darstellung mit Zahlen vorgegebener fester Genauigkeit zu entwickeln. Diese wurden erstmals in den Arbeiten [3] [7] [11] vorgestellt.

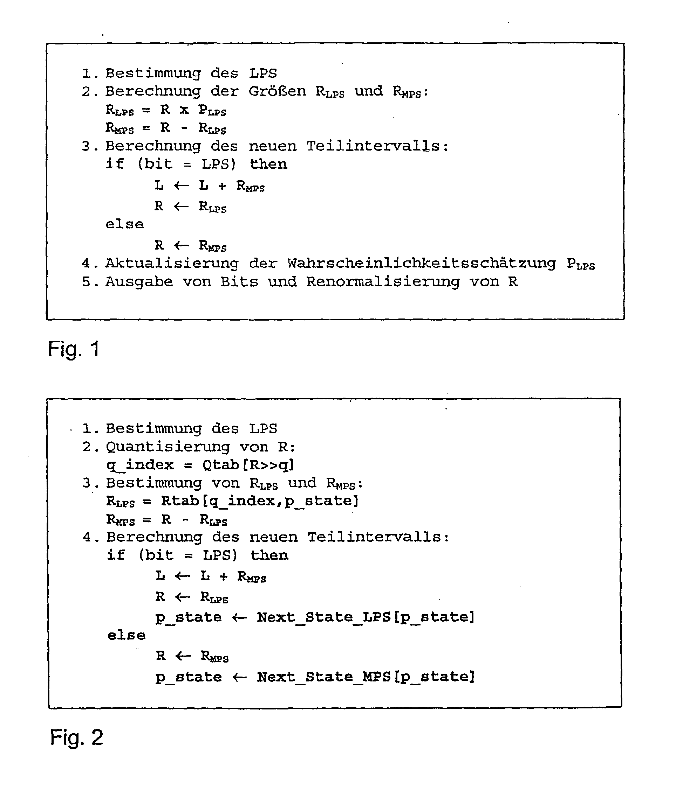

In Figur 1 sind die wesentlichen Operationen zur binären arithmetischen Kodierung skizziert. In der dargestellten Implementierung wird das aktuelle Teilintervall durch die beiden Werte $L$ und $R$ repräsentiert, wobei $L$ den Aufsatzpunkt und $R$ die Größe (Breite) des Teilintervalls bezeichnet und beide Größen mit jeweils b-bit Ganzzahlen dargestellt werden. Die Kodierung eines $bit \in \{0, 1\}$ erfolgt dabei im wesentlichen in fünf Teilschritten: Im ersten Schritt wird anhand der Wahrscheinlichkeitsschätzung der Wert des weniger wahrscheinlichen Symbols ermittelt. Für dieses Symbol, auch $LPS$ (least probable symbol) in Unterscheidung zum $MPS$ (most probable symbol) genannt, wird die Wahrscheinlichkeitsschätzung $P_{LPS}$ im zweiten Schritt zur Berechnung der Breite $R_{LPS}$ des entsprechenden Teilintervalls herangezogen. Je nach Wert des zu kodierenden Bits $bit$ werden $L$ und $R$ im dritten Schritt aktualisiert. Im vierten Schritt wird die Wahrscheinlichkeitsschätzung je nach Wert des gerade kodierten Bits aktualisiert und schließlich wird das Codeintervall $R$ im letzten Schritt einer sogenannten Renormalisierung unterzogen, d. h. $R$ wird beispielsweise so reskaliert, dass die Bedingung $R \in [2^{b-2}, 2^{b-1})$ erfüllt ist. Dabei wird bei jeder Skalierungsoperation ein Bit ausgegeben. Für weitere Details sei auf [10] verwiesen.

Der wesentliche Nachteil einer Implementierung, wie oben skizziert, besteht nun darin, dass die Berechnung der Intervallbreite $R_{LPS}$ eine Multiplikation pro zu kodierendem Symbol erfordert. Üblicherweise sind Multiplikationsoperationen, insbesondere, wenn sie in Hardware realisiert werden, aufwändig und kostenintensiv. In mehreren Forschungsarbeiten wurden daher Verfahren untersucht, diese Multiplikationsoperation durch eine geeignete Approximation zu ersetzen [11][12][13][14]. Hierbei können die zu diesem Thema veröffentlichten Verfahren grob in drei Kategorien eingeteilt werden.

Die erste Gruppe von Vorschlägen zu einer multiplikationsfreien, binären arithmetischen Kodierung basiert auf dem Ansatz, die geschätzten Wahrscheinlichkeiten $P_{LPS}$ so zu approximieren, dass die Multiplikation im 2. Schritt von Figur 1 durch eine (oder mehrere) Schiebe- und Additionsoperation(en) ersetzt werden kann [11] [14]. Hierzu werden im einfachsten Fall die Wahrscheinlichkeiten $P_{LPS}$ durch Werte in der Form $2^{-q}$ mit ganzahligem $q > 0$ angenähert.

In der zweiten Kategorie von approximativen Verfahren wird vorgeschlagen, den Wertebereich von $R$ durch diskrete Werte in der Form $(½ - r)$ zu approximieren, wobei $r \in \{0\} \cup \{2^{-k} \mid k > 0, k$ ganzzahlig$\}$ gewählt wird [15][16].

Die dritte Kategorie von Verfahren zeichnet sich schließlich dadurch aus, dass dort sämtliche arithmetische Operationen durch Tabellenzugriffe ersetzt werden. Zu dieser Gruppe von Verfahren gehören einerseits der im JPEG-Standard verwendete Q-Coder und verwandte Verfahren, wie der QM- und MQ-Coder [12], und andererseits der quasi-arithmetische Koder [13]. Während das letztgenannte Verfahren eine drastische Einschränkung der zur Repräsentierung von $R$ verwendeten Anzahl $b$ von Bits vornimmt, um zu akzeptabel dimensionierten Tabellen zu gelangen, wird im Q-Coder die Renormalisierung von $R$ so gestaltet, dass $R$ zumindest näherungsweise durch 1 approximiert werden kann. Auf diese Art und Weise wird die Multiplikation zur Bestimmung von $R_{LPS}$ vermieden. Zusätzlich wird die Wahrscheinlichkeitsschätzung mittels einer Tabelle in Form einer Finite-State Machine betrieben. Für weitere Einzelheiten hierzu sei auf [12] verwiesen.

Die Patentschrift US5592162 beschreibt ein Verfahren für die Ausführung einer arithmetischen Kodierung, wobei die Zahl der möglichen Intervallbreiten begrenzt wird.

Durch die Verwendung eines Indexes, der sich auf diese Intervallbreiten bezieht, kann eine multiplikationsfreie arithmetische Kodierung mit einem reduzierten Speicheraufwand erreicht werden.

Bei dieser Erfindung handelt es sich um ein Verfahren zur arithmetischen Kodierung, ein Verfahren zur arithmetischen Dekodierung, ein Speichermedium und ein Computerprogramm entsprechend den Ansprüchen im Anhang.

Ein Verfahren zur arithmetischen Enkodierung und Dekodierung von binären Zuständen wird vorteilhafterweise so durchgeführt, daß in einem ersten Schritt ein vorgebbarer Wertebereich für die Spezifizierung der Intervallbreite $R$ in $K$ repräsentative Intervallbreiten $\{Q_1, ..., Q_k\}$, ein vorgebbarer Wertebereich für die Spezifizierung der Wahrscheinlichkeiten in $N$ repräsentative Wahrscheinlichkeitszustände $\{P_1, ..., P_N\}$ unterteilt wird und Zuordnungsvorschriften angegeben werden, die jeder Intervallbreite $R$ ein $Q_k$ ($1 \le k \le K$) und jeder Wahrscheinlichkeit ein $P_n$ ($1 \le n \le N$) zuordnen, in einem zweiten Schritt die Enkodierung oder Dekodierung der binären Zustände erfolgt, indem die Berechnung der im Enkodier- bzw Dekodierprozess abzuleitenden neuen Intervallbreite unter Verwendung von einer repräsentativen Intervallbreite $Q_k$ ($1 \le k \le K$) und einem repräsentativen Wahrscheinlichkeitszustand $P_n$ ($1 \le n \le N$) durch von Multiplikation und Division verschiedene arithmetische Operationen durchgeführt wird, wobei die repräsentative Intervallbreite $Q_k$ durch das zugrundeliegende Basisintervall der Breite R und der repräsentative Wahrscheinlichkeitszustand $P_n$ durch die dem zu enkodierenden oder zu dekodierendem Symbol zugrundeliegende Wahrscheinlichkeitsschätzung gemäß den angegebenen Zuordnungsvorschriften bestimmt werden.

Eine andere Ausführungsform ist dadurch gekennzeichnet, daß ausgehend von dem aktuell auszuwertenden Intervall mit Breite $R$ zur Bestimmung der zugeordneten Intervallbreite $Q_k$ ein Index $q\_index$ durch eine Schiebe- und Bitmaskierungsoperation angewendet auf die rechnerinterne/binäre Darstellung von $R$ ermittelt wird.

Als vorteilhaft erweist es sich auch, wenn ausgehend von dem aktuell auszuwertenden Intervall mit Breite $R$ zur Bestimmung der zugeordneten Intervallbreite $Q_k$ ein Index $q\_index$ durch eine Schiebeoperation angewendet auf die rechnerinterne/binäre Darstellung von $R$ und einem nachgeschalteten Zugriff auf eine Tabelle $Qtab$ ermittelt wird, wobei die Tabelle Qtab die den durch Schiebeoperation vorquantisierten Werten von R entsprechenden Indizes von Intervallbreiten enthält.

Insbesondere erweist es sich als vorteilhaft, wenn die dem zu enkodierenden oder zu dekodierendem Symbol zugrundeliegende Wahrscheinlichkeitsschätzung mit Hilfe eines Indizes $p\_state$ einem Wahrscheinlichkeitszustand $P_n$ zugeordnet wird.

Es ist ebenfalls von Vorteil, wenn die Bestimmung der dem *LPS* entsprechenden Intervallbreite $R_{LPS}$ durch einen Zugriff auf eine Tabelle *Rtab* erfolgt, wobei die Tabelle *Rtab* die zu allen $K$ quantisierten Werten von $R$ und den $N$ verschiedenen Wahrscheinlichkeitszuständen korrespondierenden Werte der Intervallbreite $R_{LPS}$ als Produktwerte $(Q_k * P_n)$ enthält. Der Rechenaufwand wird insbesondere dann reduziert, wenn die Bestimmung der dem LPS entsprechenden Intervallbreite $R_{LPS}$ durch einen Zugriff auf die Tabelle *Rtab* erfolgt, wobei zur Auswertung der Tabelle der Quantisierungsindex $q\_index$ und der Index des Wahrscheinlichkeitszustand $p\_state$ verwendet wird.

Es ist weiterhin vorgesehen, daß bei dem Verfahren für die $N$ verschiedenen repräsentativen Wahrscheinlichkeitszustände Übergangsregeln vorgegeben werden, wobei die Übergangsregeln angeben, welcher neue Zustand ausgehend von dem aktuell enkodierten oder dekodierten Symbol für das nächste zu kodierende oder dekodierende Symbol verwendet wird. Hierbei erweist es sich von Vorteil, wenn eine Tabelle *Next_State_LPS* angelegt wird, welche zu dem Index $n$ des aktuell gegebenen Wahrscheinlichkeitszustands $P_n$ den Index $m$ des neuen Wahrscheinlichkeitszustands $P_m$ bei Auftreten eines least probable symbol (LPS) enthält, und/oder eine Tabelle *Next_State_MPS* angelegt wird, welche zu dem Index $n$ des aktuell gegebenen Wahrscheinlichkeitszustands $P_n$ den Index $m$ des neuen Wahrscheinlichkeitszustands $P_m$ bei Auftreten eines most probable symbol (MPS) enthält.

Eine Optimierung des Verfahrens zur tabellengestützten binären arithmetischen Enkodierung und Dekodierung wird insbesondere dadurch erreicht, daß die zu allen $K$ Intervallbreiten und zu allen $N$ verschiedenen Wahrscheinlichkeitszustands korrespondierenden Werte der Intervallbreite $R_{LPS}$ als Produktwerte ($Q_k * P_n$) in einer Tabelle *Rtab* abgelegt werden.

Eine weitere Optimierung erreicht man, wenn die Anzahl $K$ der Quantisierungswerte und/oder die Anzahl $N$ der repräsentativen Zustände in Abhängigkeit der vorgegebenen Genauigkeit der Kodierung und/oder in Abhängigkeit des verfügbaren Speicherplatzes gewählt werden.

Eine Enkodierung umfasst beispielsweise folgende Schritte:

```
1.    Bestimmung des LPS
2.    Quantisierung von R:
      q_index = Qtab [R>>q]
3.    Bestimmung von R_LPS und R :
      R_LPS = Rtab [q_index, p_state]
      R = R - R_LPS

4.    Berechnung des neuen Teilintervalls:
      if (bit = LPS) then
          L ← L + R
          R ← R_LPS
          p_state ← Next_State_LPS [p_state]
          if (p_state = 0) then valMPS ← 1 - valMPS
      else
          p_state ← Next_State_MPS [p_state],

5.    Renormalisierung von L und R, Schreiben von Bits,
      wobei
      q_index   den Index eines aus Qtab ausgelesenen Quantisierungswertes,

      p_state   den aktuellen Zustand,
      R_LPS     die dem LPS entsprechende Intervallbreite und
      valMPS    das dem MPS entsprechende Bit
                beschreiben.
```

Die Dekodierung umfasst beispielsweise folgende Schritte:

1.    Bestimmung des LPS

2.    Quantisierung von R:

**q_index = Qtab [R>>q]**

3.    Bestimmung von $R_{LPS}$ und R :

$R_{LPS}$ **= Rtab [q_index, p_state]**

**R = R − $R_{LPS}$**

4.    Bestimmung von *bit*, je nach Lage des Teilintervalls:

**if** (V $\geq$ R) **then**

**bit ← LPS**

**V ← V − R**

**R ← $R_{LPS}$**

    **if (P_state = 0) valMPS ← 1 − valMPS**

    **p_state ← Next_State_LPS [p_state]**

**else**


    **bit ← MPS**

    **p_state ← Next_State_MPS [p_state]**


5.    Renormalisierung von R, Auslesen eines Bits und Aktualisierung von V,

wobei

**q_index**    den Index eines aus Qtab ausgelesenen Quantisierungswertes,
**p_state**    den aktuellen Zustand,
**$R_{LPS}$**    die dem LPS entsprechende Intervallbreite,
**valMPS**    das dem MPS entsprechende Bit und
**V**    einen Wert aus dem Innern des aktuellen Teilintervalls

beschreiben.

In einem anderen Verfahren ist vorgesehen, daß bei der Enkodierung und/oder Dekodierung die Berechnung des Quantisierungsindex *q_index* im zweiten Teilschritt nach der Berechnungsvorschrift erfolgt:


$$\text{q\_index} = (R>>q) \& Qmask$$


wobei Qmask eine in Abhängigkeit von *K* geeignet gewählte Bitmaske darstellt.

Bei Vorliegen einer uniformen Wahrscheinlichkeitsverteilung lässt sich eine weitere Optimierung des Verfahrens zur tabellengestützten binären arithmetischen Enkodierung und Dekodierung erreichen, indem

-    bei der Enkodierung nach dem ersten speziellen Ausführungsbeispiel die Teilschritte 1 bis 4 nach folgender Berechnungsvorschrift erfolgen:

```
R ← R>>1
if (bit = 1) then
      L ← L + R,
```

oder die Teilschritte 1 bis 4 der Enkodierung nach dem ersten speziellen Ausführungsbeispiel gemäß folgender Berechnungsvorschrift erfolgen:

```
L ← L << 1
if (bit = 1) then
      L ← L + R
```

und bei der letzten Alternative die Renormalisierung (Teilschritt 5 nach dem ersten speziellen Ausführungsbeispiel) mit verdoppelten Entscheidungsschwellwerten erfolgt und keine Verdoppelung von *L* und *R* vorgenommen wird, bei der Dekodierung nach dem zweiten speziellen Ausführungsbeispiel die Teilschritte 1 bis 4 nach folgender Berechnungsvorschrift erfolgen:

```
R ← R >> 1
if (V ≥ R) then
        bit ← 1
        V ← V - R
else
        bit ← 0,
```

oder

die Teilschritte 1 bis 5 der Dekodierung nach dem zweiten speziellen afb gemäß folgender Berechnungsschrift ausgeführt warden:

    1. Auslesen eines Bits und Aktualisierung von *V*
    2. Bestimmung von bit, je nach Lage des Teilintervalls:

```
if (V ≥ R) then
        bit ← 1
        V ← V - R
else
bit ← 0.
```

Es erweist sich weiterhin als vorteilhaft, wenn die Initialisierung der Wahrscheinlichkeitsmodelle in Abhängigkeit eines Quantisierungsparameters SliceQP und vorgegebener Modellparameter m und n erfolgt, wobei SliceQP den am Beginn eines Slices vorgegebenen Quantisierungsparamter und m und n die Modellparameter beschreiben.

Ebenso ist es vorteilhaft, wenn die Initialisierung der Wahrscheinlichkeitsmodelle folgende Schritte umfasst:

```
1. preState = min(max(1,((m * SliceQP)>>4)+n),2*N)
2. if (preState <= N) then
        p_state = N+1 - preState
        valMPS = 0
   else
        p_state = preState - N
        valMPS = 1,
```

wobei valMPS das dem MPS entsprechende Bit, SliceQP den am Beginn eines Slices vorgegebenen Quantisierungsparamter und m und n die Modellparameter beschreiben.

Eine Anordnung zur arithmetischen Enkodierung und Dekodierung von binären Zuständen umfasst mindestens einen Prozessor, der (die) derart eingerichtet ist (sind), dass ein Verfahren zur arithmetischen Enkodierung und Dekodierung durchführbar ist, wobei in einem ersten Schritt ein vorgebbarer Wertebereich für die Spezifizierung der Intervallbreite $R$ in $K$ repräsentative Intervallbreiten $\{Q_1, ..., Q_K\}$, ein vorgebbarer Wertebereich für die Spezifizierung der Wahrscheinlichkeiten in $N$ repräsentative Wahrscheinlichkeitszustände $\{P_1, ..., P_N\}$ unterteilt wird und Zuordnungsvorschriften angegeben werden, die jeder Intervallbreite $R$ ein $Q_k$ ($1 \leq k \leq K$) und jeder Wahrscheinlichkeit ein $P_n$ ($I \leq n \leq N$) zuordnen, in einem zweiten Schritt die Enkodierung oder Dekodierung der binären Zustände erfolgt, indem die Berechnung der im Enkodier- bzw Dekodierprozess abzuleitenden neuen Intervallbreite unter Verwendung von einer repräsentativen Intervallbreite $Q_k$ ($1 \leq k \leq K$) und einem repräsentativen Wahrscheinlichkeitszustand $P_n$ ($1 \leq n \leq N$) durch von Multiplikation und Division verschiedene arithmetische Operationen durchgeführt wird, wobei die repräsentative Intervallbreite $Q_k$ durch das zugrundeliegende Basisintervall der Breite R und der repräsentative Wahrscheinlichkeits-zustand $P_n$ durch die dem zu enkodierenden oder zu dekodierendem Symbol zugrundeliegende Wahrscheinlichkeitsschätzung gemäß den angegebenen Zuordnungsvorschriften bestimmt werden.

Ein Computerprogramm zur arithmetischen Enkodierung und Dekodierung von binären Zuständen ermöglicht es einem Computer, nachdem es in den Speicher des Computers geladen worden ist, ein Verfahren zur arithmetischen Enkodierung und Dekodierung durchzuführen, wobei in einem ersten Schritt ein vorgebbarer Wertebereich für die Spezifizierung der Intervallbreite $R$ in $K$ repräsentative Intervallbreiten $\{Q_1, ..., Q_K\}$, ein vorgebbarer Wertebereich für die Spezifizierung der Wahrscheinlichkeiten in $N$ repräsentative Wahrscheinlichkeitszustände $\{P_1, ..., P_N\}$ unterteilt wird und Zuordnungsvorschriften angegeben werden, die jeder Intervallbreite $R$ ein $Q_k$ ($1 \leq k \leq K$) und jeder Wahrscheinlichkeit ein $P_n$ ($1 \leq n \leq N$) zuordnen, in einem zweiten Schritt die Enkodierung oder Dekodierung der binären Zustände erfolgt, indem die Berechnung der im Enkodier- bzw Dekodierprozess abzuleitenden neuen Intervallbreite unter Verwendung von einer repräsentativen Intervallbreite $Q_k$ ($1 \leq k \leq K$) und einem repräsentativen Wahrscheinlichkeitszustand $P_n$ ($1 \leq n \leq N$) durch von Multiplikation und Division verschiedene arithmetische Operationen durchgeführt wird, wobei die repräsentative Intervallbreite $Q_k$ durch das zugrundeliegende Basisintervall der Breite R und der repräsentative Wahr-scheinlichkeitszustand $P_n$ durch die dem zu enkodierenden oder zu dekodierendem Symbol zugrundeliegende Wahrscheinlichkeitsschätzung gemäß den angegebenen Zuordnungsvorschriften bestimmt werden.

Beispielsweise können solche Computerprogramme (gegen Gebühr oder unentgeltlich, frei zugänglich oder passwortgeschützt) downloadbar in einem Daten- oder Kommunikationsnetz bereitgestellt werden. Die so bereitgestellten Computerprogramme können dann durch ein Verfahren nutzbar gemacht werden, bei dem ein Computerprogramm nach Anspruch 22 aus einem Netz zur Datenübertragung wie beispielsweise aus dem Internet auf eine an das Netz angeschlossene Datenverarbeitungseinrichtung heruntergeladen wird.

Zur Durchführung eines Verfahrens zur arithmetischen Enkodierung und Dekodierung von binären Zuständen wird vorteilhafterweise ein computerlesbares Speichermedium genutzt, auf dem ein Programm gespeichert ist, das es einem Computer ermöglicht, nachdem es in den Speicher des Computers geladen worden ist, ein Verfahren zur arithmetischen Enkodierung und Dekodierung durchzuführen, wobei in einem ersten Schritt ein vorgebbarer Wertebereich für die Spezifizierung der Intervallbreite $R$ in $K$ repräsentative Intervallbreiten $\{Q_1, ..., Q_k\}$, ein vorgebbarer Wertebereich für die Spezifizierung der Wahrscheinlichkeiten in $N$ repräsentative Wahrscheinlichkeitszustände $\{P_1, ..., P_N\}$ unterteilt wird und Zuordnungsvorschriften angegeben werden, die jeder Intervallbreite $R$ ein $Q_k$ ($1 \leq k \leq K$) und jeder Wahrschein-lichkeit ein $P_n$ ($1 \leq n \leq N$) zuordnen, in einem zweiten Schritt die Enkodierung oder Dekodierung der binären Zustände erfolgt, indem die Berechnung der im Enkodier- bzw Dekodierprozess abzuleitenden neuen Intervallbreite unter Verwendung von einer repräsentativen Intervallbreite $Q_k$ ($1 \leq k \leq K$) und einem repräsentativen Wahrscheinlichkeitszustand $P_n$ ($1 \leq n \leq N$) durch von Multiplikation und Division verschiedene arithmetische Operationen durchgeführt wird, wobei die repräsentative Intervallbreite $Q_k$ durch das zugrundeliegende Basisintervall der Breite R und der repräsentative Wahrscheinlichkeitszustand $P_n$ durch die dem zu enkodierenden oder zu dekodierendem Symbol zugrundeliegende Wahrscheinlichkeitsschätzung gemäß den angegebenen Zuordnungsvorschriften bestimmt werden.

Die Erfindung wird nachfolgend anhand eines in der Zeichnung dargestellten Ausführungsbeispiels näher erläutert.

Es zeigen:

Figur 1   Darstellung der wesentlichen Operationen zur binären arithmetischen Kodierung;

Figur 2   Modifiziertes Schema zur tabellengestützten arithmetischen Enkodierung;

Figur 3   Prinzip der tabellengestützten arithmeti- schen Decodierung;

Figur 4   Prinzip der En- bzw. Dekodierung für binäre Daten mit uniformer Verteilung;

Figur 5   Alternative Realisierung der En- bzw. Dekodierung für binäre Daten mit uniformer Verteilung.

Figur 6   Initialisierung der Wahrscheinlichkeits- modelle in Abhängigkeit eines Quantisierungsparameters SliceQP und vorgegebener Modellparameter m und n

Zunächst einmal soll jedoch der theoretische Hintergrund etwas näher erläutert werden:

Tabellengestützte Wahrscheinlichkeitsschätzung

Wie oben bereits näher erläutert, beruht die Wirkungsweise der arithmetischen Kodierung auf einer möglichst guten Schätzung der Auftrittswahrscheinlichkeit der zu kodierenden Symbole. Um eine Adaption an instationäre Quellenstatistiken zu ermöglichen, muss diese Schätzung im Laufe des Kodierungsprozesses aktualisiert werden. In der Regel werden hierzu herkömmlicherweise Verfahren verwendet, die mit Hilfe skalierter Häufigkeitszähler der kodierten Ereignisse operieren [17]. Bezeichnen $C_{LPS}$ und $c_{MPS}$ Zähler für die Auftrittshäufigkeiten von $LPS$ und $MPS$, so lässt sich mittels dieser Zähler die Schätzung

$$P_{LPS} = \frac{c_{LPS}}{c_{LPS} + c_{MPS}} \tag{1}$$

vornehmen und damit die in Figur 1 skizzierte Operation der Intervallunterteilung ausführen. Für praktische Zwecke nachteilig ist die in Gleichung (1) erforderliche Division. Häufig ist es jedoch zweckmäßig und erforderlich, bei Überschreitung eines vorgegebenen Schwellwerts $C_{max}$ des Gesamtzählers $c_{Total} = c_{MPS} + c_{LPS}$ eine Reskalierung der Zählerstände vorzunehmen. (Man beachte in diesem Zusammenhang, dass bei einer $b$-bit-Darstellung von $L$ und $R$ die kleinste Wahrscheinlichkeit, die noch korrekt dargestellt werden kann, $2^{-b+2}$ beträgt, so dass zur Vermeidung der Unterschreitung dieser unteren Grenze gegebenenfalls eine Reskalierung der Zählerstände erforderlich ist.) Bei geeigneter Wahl von $C_{max}$ lassen sich die reziproken Werte von $C_{Total}$ tabellieren, so dass die in Gleichung (1) erforderliche Division durch einen Tabellenzugriff sowie eine Multiplikations- und Schiebeoperation ersetzt werden kann. Um jedoch auch diese arithmetischen Operationen zu vermeiden, wird in der vorliegenden Erfindung ein vollständig tabellengestütztes Verfahren zur Wahrscheinlichkeitsschätzung verwendet.

Zu diesem Zweck werden vorab in einer Trainingsphase repräsentative Wahrscheinlichkeitszustände $\{P_k \mid 0 \leq k < N_{max}\}$ ausgewählt, wobei die Auswahl der Zustände einerseits von der Statistik der zu kodierenden Daten und andererseits von der Nebenbedingung der vorgegebenen Maximalanzahl $N_{max}$ von Zuständen abhängt. Zusätzlich werden Übergangsregeln definiert, die angeben, welcher neue Zustand ausgehend von dem aktuell kodierten Symbol für das nächste zu kodierende Symbol verwendet werden soll. Diese Übergangsregeln werden in Form zweier Tabellen bereitgestellt: $\{Next\_State\_LPS_k \mid 0 \leq k < N_{max}\}$ und $\{Next\_State\_MPS_k \mid 0 \leq k < N_{max}\}$, wobei die Tabellen für den Index $n$ des aktuell gegebenen Wahrscheinlichkeitszustands $P_n$ den Index m des neuen Wahrscheinlichkeitszustands $P_m$ bei Auftreten eines LPS bzw. MPS liefern. Hervorzuheben sei an dieser Stelle, dass zur Wahrscheinlichkeitsschätzung im arithmetischen Enkoder bzw. Dekoder, so wie er hier vorgeschlagen wird, keine explizite Tabellierung der Wahrscheinlichkeitszustände notwendig ist. Vielmehr werden die Zustände nur anhand ihrer entsprechenden Indizes implizit adressiert, wie im nachfolgenden Abschnitt beschrieben. Zusätzlich zu den Übergangsregeln muss spezifiziert werden, bei welchen Wahrscheinlichkeitszuständen der Wert des LPS und MPS vertauscht werden muss. In der Regel wird es nur einen solchen ausgezeichneten Zustand geben, der dann anhand seines Indizes $p\_state$ identifiziert werden kann.

Tabellengestützte Intervallunterteilung

Figur 2 zeigt das modifizierte Schema zur tabellengestützten arithmetischen Kodierung, wie sie hier vorgeschlagen wird. Nach Bestimmung des $LPS$ wird zunächst die gegebene Intervallbreite $R$ mittels einer tabellierten Abbildung $Qtab$ und einer geeigneten Schiebeoperation (um $q$ bit) auf einen quantisierten Wert $Q$ abgebildet. Alternativ kann die Quantisierung in Sonderfällen auch ohne Zuhilfenahme einer tabellierten Abbildung $Qtab$ nur mit Hilfe einer Kombination von Schiebe- und Maskierungsoperationen ausgeführt werden. In der Regel wird hier eine relativ grobe Quantisierung auf $K = 2...8$ repräsentative Werte vorgenommen. Auch hier erfolgt, ähnlich wie im Fall der Wahrscheinlichkeitsschätzung, keine explizite Bestimmung von $Q$; vielmehr wird nur ein Index $q\_index$ auf $Q$ übergeben. Dieser Index wird nun zusammen mit dem Index $p\_state$ zur Charakterisierung des aktuellen Wahrscheinlichkeitszustands für die Bestimmung der Intervallbreite $R_{LPS}$ verwendet. Dazu wird der entsprechende Eintrag der Tabelle $Rtab$ verwendet. Dort sind die zu allen $K$ quantisierten Werten von $R$ und $N_{max}$ verschiedenen Wahrscheinlichkeitszuständen korrespondierenden $K \cdot N_{max}$ Produktwerte $R \times P_{LPS}$ als Ganzzahlwerte mit einer' Genauigkeit von i.a. $b$-2 Bits abgelegt. Für praktische Implementierungen ist hier eine Möglichkeit gegeben, zwischen dem Speicherbedarf für die Tabellengröße und der arithmetischen Genauigkeit, die letztlich auch die Effizienz der Kodierung bestimmt; abzuwägen. Beide Zielgrößen werden durch die Granularität der Repräsentierung von R und $P_{LPS}$ bestimmt.

Im vierten Schritt der Figur 2 ist gezeigt, wie die Aktualisierung des Wahrscheinlichkeitszustands $p\_state$ in Abhängigkeit des gerade kodierten Ereignisses *bit* vorgenommen wird. Hier werden die im vorigen Abschnitt "Tabellengestützte Wahrscheinlichkeitsschätzung" bereits erwähnten Übergangstabellen $Next\_State\_LPS$ und $Next\_State\_MPS$ benutzt. Diese Operationen entsprechen dem in Figur 1 im 4. Schritt angegebenen, aber nicht näher spezifizierten Aktualisierungsprozeß.

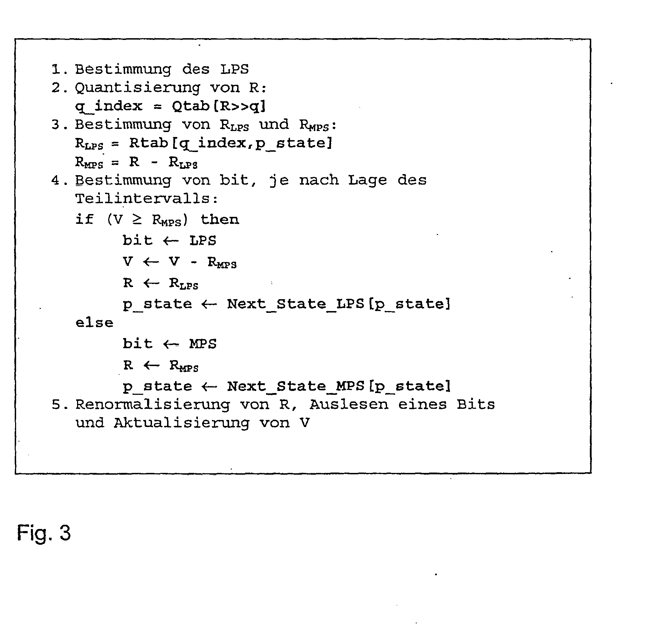

Figur 3 zeigt das korrespondierende Ablaufschema der tabellengestützten arithmetischen Dekodierung. Zur Charakterisierung des aktuellen Teilintervalls wird im Dekoder die Intervallbreite $R$ und ein Wert $V$ verwendet. Letzterer liegt im Innern des Teilintervalls und wird mit jedem gelesenen Bit sukzessive verfeinert. Wie aus der Figur 3 hervorgeht, werden die Operationen zur Wahrscheinlichkeitsschätzung und Bestimmung der Intervallbreite $R$ entsprechend denen des Enkoders nachgeführt.

Kodierung mit uniformer Wahrscheinlichkeitsverteilung In Anwendungen, in denen z. B. vorzeichenbehaftete Werte kodiert werden sollen, deren Wahrscheinlichkeitsverteilung symmetrisch um die Null angeordnet ist, wird man zur Kodierung der Vorzeicheninformation in der Regel von einer Gleichverteilung ausgehen können. Da diese Information einerseits mit in den arithmetischen Bitstrom eingebettet werden soll, es andererseits aber nicht sinnvoll ist, für den Fall einer Wahrscheinlichkeit von P ≈ 0.5 den immer noch relativ aufwändigen Apparat der tabellengestützten Wahrscheinlichkeitsschätzung und Intervallunterteilung zu benutzen, wird vorgeschlagen für diesen Spezialfall, optional eine gesonderte Enkoder-/Dekoder Prozedur zu benutzen, die sich wie folgt darstellt.

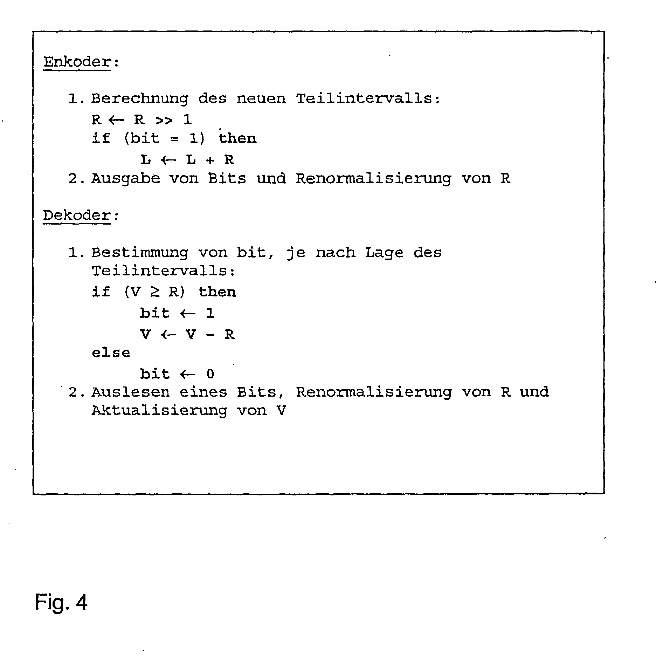

Im Enkoder lässt sich für diesen Spezialfall die Intervallbreite des neuen Teilintervalls durch eine einfache Schiebeoperation entsprechend einer Halbierung der Breite des Ausgangsintervalls $R$ bestimmen. Je nach Wert des zu kodierenden Bits wird dann die obere bzw. untere Hälfte von $R$ als neues Teilintervall gewählt (vgl. Figur 4). Die anschließende Renormalisierung und Ausgabe von Bits erfolgt wie im obigen Fall der tabellengestützten Lösung.

Im entsprechenden Dekoder reduzieren sich die notwendigen Operationen darauf, das zu dekodierende Bit anhand des Werts von $V$ relativ zur aktuellen Intervallbreite $R$ durch eine einfache Vergleichsoperation zu bestimmen. In dem Fall, dass das dekodierte Bit gesetzt wird, ist $V$ um den Betrag von $R$ zu reduzieren. Wie in Figur 4 dargestellt, wird die Dekodierung durch die Renormalisierung und die Aktualisierung von V mit dem nächsten einzulesenden Bit abgeschlossen.

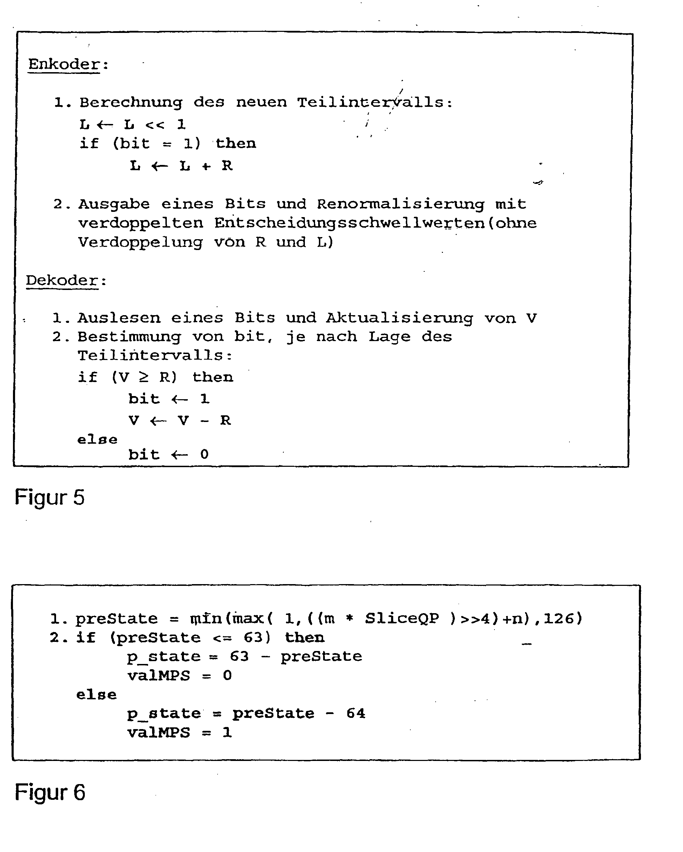

Eine alternative Realisierung der Kodierung von Ereignissen mit uniformer Wahrscheinlichkeitsverteilung ist in Figur 5 dargestellt. In dieser beispielhaften Implementierung wird die aktuelle Intervallbreite $R$ nicht modifiziert. Stattdessen wird im Enkoder zunächst $V$ durch eine Schiebeoperation verdoppelt. Je nach Wert des zu kodierenden Bits wird dann, ähnlich wie im vorigen Beispiel, die obere bzw. untere Hälfte von $R$ als neues Teilintervall gewählt (vgl. Figur 5). Die anschließende Renormalisierung und Ausgabe von Bits erfolgt wie im obigen Fall der tabellengestützten Lösung, mit dem Unterschied, dass die Verdoppelung von $R$ und $L$ nicht ausgeführt wird und die entsprechenden Vergleichsoperationen mit verdoppelten Schwellwerten ausgeführt werden.

Im entsprechenden Dekoder der alternativen Realisierung wird zunächst ein Bit ausgelesen und $V$ aktualisiert. Der zweite Schritt vollzieht sich in derselben Art und Weise wie Schritt 1 in Figur 4, d.h., das zu dekodierende Bit wird anhand des Werts von $V$ relativ zur aktuellen Intervallbreite $R$ durch eine einfache Vergleichsoperation bestimmt, und in dem Fall, in dem das dekodierte Bit gesetzt wird, ist $V$ um den Betrag von $R$ zu reduzieren (vgl. Figur 5).

Adressierung und Initialisierung der Wahrscheinlichkeitsmodelle

Jedes Wahrscheinlichkeitsmodell, wie es in der vorgestellten Erfindung Verwendung findet, wird mit Hilfe zweier Parameter gekennzeichnet: 1) der Index $p\_state,$ der den Wahrscheinlichkeitszustand des $LPS$ charakterisiert, und 2) der Wert $valMPS$ des $MPS$. Jede dieser beiden Größen muss zu Anfang der Enkodierung bzw. Dekodierung einer abgeschlossenen Kodiereinheit (in Anwendungen der Videokodierung etwa ein Slice) initialisiert werden. Die Initialisierungswerte können dabei aus Steuerinformationen, etwa dem Quantisierungsparameter (eines Slices) abgeleitet werden, wie es in Figur 6 beispielhaft dargestellt ist. Vorwärtsgesteuerter Initialisierungsprozeß

Eine weitere Möglichkeit der Anpassung der Startverteilungen der Modelle wird durch folgende Methode bereitgestellt. Um eine bessere Anpassung der Initialisierungen der Modelle zu gewährleisten, kann im Enkoder eine Auswahl von vorgegebenen Startwerten der Modelle bereitgestellt werden. Diese Modelle können zu Gruppen von Startverteilungen zusammengefasst und mit Indizes adressiert werden, so dass im Enkoder die adaptive Auswahl einer Gruppe von Startwerten erfolgt und dem Dekoder in Form eines Indizes als Seiteninformation übermittelt wird. Diese Methode wird als vorwärtsgesteuerter Initialisierungsprozeß bezeichnet.

Schließlich wird noch mal abschließend auf die Möglichkeit hingewiesen, dass die Anzahl von möglichen Quantisierungsindizes und/oder die Anzahl der Wahrscheinlichkeitszustände in Abhängigkeit der vorgegebenen Genauigkeit der Kodierung und/oder in Abhängigkeit des verfügbaren Speicherplatzes gewählt sein kann.Die Wahrscheinlichkeitsschätzung der Zustände kann mittels einer endlichen Zustandsmaschine (finite state machine; FSM) erfolgen. Zudem ist es möglich, dass die Generierung der Wahrscheinlichkeitszustände offline erfolgt. Schließlich kann vorgesehen sein, dass die Auswahl der Zustände von der Statistik der zu kodierenden Daten und/oder von der Anzahl der Zustände abhängt.

## Quellennachweis

[1] T. Wiegand, G. Sullivan, "Draft Text of Final Draft International Standard (FDIS) of Joint Video Specification (ITU-T Rec. H.264 | ISO/IEC 14496-10 AVC)", JVT-G050, March 2003.

[2] D. A. Huffman, "A Method for Construction of Minimum Redundancy code", Proc. IRE, Vol. 40, pp. 1098-1101, 1952.

[3] I. H. Witten, R. M. Neal, J. G. Cleary, "Arithmetic Coding for Data Compression", Communication of the ACM, Vol. 30, No. 6, pp. 520-540, 1987.

[4] G. G. Langdon, J. Rissanen, "A Simple General Binary Source code", IEEE Transactions on Information Theory, Vol. 28, pp. 800-803, 1982.

[5] C. E. Shannon, "A Mathematical Theory of Communication", Bell Syst. Tech. Journal, vol. 27, pp. 379-423, 623-656, 1948.

[6] P. Elias, in "Information Theory and Coding", N. Abramson (Ed.), New York, Mc-Gra-Hill, 1963.

[7] J. Rissanen, "Generalized Kraft Inequality and Arithmetic Coding", IBM J. Res. Develop., Vol. 20, pp. 198-203. 1976.

[8] R. C. Pasco, "Source Coding and Algorithms for Fast Data Compression", Ph. D. Dissertation, Stanford University, USA, 1976.

[9] G. G. Langdon, "An Introduction to Arithmetic Coding", IBM J. Res. Develop., Vol. 28, pp. 135-149, 1984.

[10] A. Moffat, R. M. Neal, I. H. Witten, "Arithmetic Coding Revisited", Proc. IEEE Data Compression Conference, Snowbird (USA), pp. 202-211, 1996.

[11] J. Rissanen, K. M. Mohiuddin, "A Multiplication-Free Multialphabet Arithmetic Arithmetic Code", IEEE Trans. on Communication, Vol. 37, pp. 93-98, 1989.

[12] W. B. Pennebaker, J. L. Mitchell, G. G. Langdon, R. B. Arps, "An Overview of the Basic Principles of the Q-Coder Adaptive Binary Arithmetic Coder", IBM J. Res. Develop., Vol. 32, pp. 717-726, 1988.

[13] P. G. Howard, J. S. Vitter, "Practical Implementations of Arithmetic Coding", in "Image and Text Compression", J. Storer (Ed.), Norwell (USA), Kluwer, 1992.

[14] L. Huynh, A. Moffat, "A Probability-Ratio Approach to Approximate Binary Arithmetic Coding", IEEE Trans. on Information Theory, Vol. 43, pp. 1658-1662, 1997.

[15] D. Chevion, E. D. Karnin, E. Walach, "High-Efficiency, Multiplication Free Approximation of Arithmetic Coding", Proc. IEEE Data Compression Conferenc, Snowbird (USA), pp. 43-52, 1991.

[16] G. Feygin, P. G. Gulak, P. Chow, "Minimizing Excess Code Length and VLSI Complexity in the Multiplication Free Approximation of Arithmetic Coding", Inform. Proc. Manag., vol. 30, pp. 805-816, 1994.

[17] D. L. Duttweiler, Ch. Chamzas, "Probability Estimation in Arithmetic and Adaptive-Huffman Entropy Coders", IEEE Trans. on Image Processing, Vol. 4, pp. 237- 246, 1995.

## Patentansprüche

1. Verfahren zur arithmetischen Enkodierung eines zu enkodierenden Symbols mit binärem Zustand auf der Grundlage einer aktuellen Intervallbreite $\overline{R}$ und einer eine Wahrscheinlichkeitsschätzung für das zu enkodierende Symbol darstellenden Wahrscheinlichkeit, wobei die Wahrscheinlichkeit $P_{LPS}$ des weniger wahrscheinlichen Symbols durch einen Wahrscheinlichkeitsindex zur Adressierung eines Wahrscheinlichkeitszustands aus einer Mehrzahl von $N_{max}$ repräsentativen Wahrscheinlichkeitszuständen $P_n$ repräsentiert ist, wobei das Verfahren folgenden Schritt aufweist:

   Enkodieren des zu enkodierenden Symbols, indem folgende Teilschritte ausgeführt werden:

Abbilden der aktuellen Intervallbreite auf einen Quantisierungsindex aus einer Mehrzahl von K repräsentativen Quantisierungsindizes die repräsentativen Intervallbreiten $Q_k$ zugeordnet sind; und Durchführen der Intervallunterteilung durch Zugreifen unter Verwendung des Quantisierungsindex und des Wahrscheinlichkeitsindex auf eine Intervallteilungstabelle bestehend aus $K*N_{max}$ Produktwerten $Q_k$ x $P_n$, um einen Teilintervallbreitenwert zu erhalten.

2. Verfahren zur arithmetischen Dekodierung eines enkodierten Symbols mit binärem Zustand auf der Grundlage einer aktuellen Intervallbreite *R* und einer eine Wahrscheinlichkeitsschätzung für das enkodierte Symbol darstellenden Wahrscheinlichkeit, wobei die Wahrscheinlichkeit $P_{LPS}$ des weniger wahrscheinlichen Symbols durch einen Wahrscheinlichkeitsindex eines Wahrscheinlichkeitszustands aus einer Mehrzahl von $N_{max}$ repräsentativen Wahrscheinlichkeitszuständen $P_n$ repräsentiert ist, wobei das Verfahren folgenden Schritt aufweist:

Dekodieren des enkodierten Symbols, indem folgende Teilschritte ausgeführt werden:

Abbilden der aktuellen Intervallbreite auf einen Quantisierungsindex aus einer Mehrzahl von K = 2...8 repräsentativen Quantisierungsindizes die repräsentativen Intervallbreiten $Q_k$ zugeordnet sind; und Durchführen der Intervallteilung durch Zugreifen unter Verwendung des Quantisierungsindex und des Wahrscheinlichkeitsindex auf eine Intervallteilungstabelle bestehend aus $K*N_{max}$ Produktwerten $Q_k$ x $P_n$; um einen Teilintervallbreitenwert zu erhalten.

3. Verfahren nach Anspruch 2, bei dem das Dekodieren ferner mittels folgenden Schrittes stattfindet:

Aktualisieren der aktuellen Intervallbreite unter Verwendung des Teilintervallbreitenwertes, um eine neue, aktualisierte Intervallbreite zu erhalten.

4. Verfahren nach einem der Ansprüche 2 bis 3, bei dem die Aktualisierung der aktuellen Intervallbreite ferner abhängig von einem im Inneren eines neuen Teilintervalls liegenden Wertes durchgeführt wird, das durch die aktuelle Teilintervallbreite und den im Inneren eines neuen Teilintervalls liegenden Wertes charakterisiert ist.

5. Verfahren nach Anspruch 4, bei dem das Dekodieren ferner mittels folgenden Teilschrittes durchgeführt wird: Gleichsetzen des binären Zustands des enkodierten Symbols mit einem weniger wahrscheinlichen oder einem wahrscheinlicheren Zustand abhängig davon, ob der im Inneren des neuen Teilintervalls liegende Wert größer gleich oder kleiner einer Differenz aus dem Wert der aktuellen Intervallbreite und dem Teilintervallbreitewert ist.

6. Verfahren nach einem der Ansprüche 4 oder 5, bei dem das Enkodieren ferner mittels eines Aktualisierens des im Inneren des neuen Teilintervalls liegenden Wertes mit einem nächsten einzulesenden Bit durchgeführt wird.

7. Verfahren nach einem Ansprüche 4 bis 6, das ferner folgenden Schritt aufweist:

Aktualisierung der Wahrscheinlichkeitsschätzung, wobei die Aktualisierung der Wahrscheinlichkeitsschätzung das Nachschlagen, mit dem Wahrscheinlichkeitsindex, in einer LPS-Übergangsregeltabelle (*Next_State_LPS*), um einen neuen Wahrscheinlichkeitsindex zu erhalten, wenn der im Inneren des neuen Teilintervalls liegende Wert größer gleich einer Differenz aus dem Wert der aktuellen Intervallbreite und dem Teilintervallbreitewert ist, und das Nachschlagen, mit dem Wahrscheinlichkeitsindex, in einer MPS-Übergangsregeltabelle (*Next_State_MPS*), um einen neuen Wahrscheinlichkeitsindex zu erhalten, wenn der im Inneren des neuen Teilintervalls liegende Wert kleiner einer Differenz aus dem Wert der aktuellen Intervallbreite und dem Teilintervallbreitewert ist, aufweist

8. Verfahren nach einem der Ansprüche 4 bis 7, das ferner das Umstellen eines den wahrscheinlicheren Zustand des enkodierten Symbols anzeigenden Wertes von einem ursprünglich angezeigten Zustand auf einen unterschiedlichen binären Zustand aufweist, wenn der Wahrscheinlichkeitsindex einem vorbestimmten Wahrscheinlichkeitsindex gleicht und der im Inneren des neuen Teilintervalls liegende Wert größer gleich einer Differenz aus dem Wert der aktuellen Intervallbreite und dem Teilintervallbreitewert ist.

9. Verfahren nach einem der vorhergehenden Ansprüche, bei dem die aktuelle Intervallbreite mit einer Genauigkeit von b Bits und der von der Intervallteilungstabelle erhaltene Teilintervallbreitenwert mit einer Genauigkeit von b-2 Bits dargestellt ist.

10. Computerprogramm, das es einem Computer ermöglicht, nachdem es in den Speicher des Computers geladen worden ist, ein Verfahren gemäß Anspruch 1 oder 2 durchzuführen.

11. Computerlesbares Speichermedium, auf dem ein Programm gespeichert ist, das es einem Computer ermöglicht, nachdem es in den Speicher des Computer geladen worden ist, ein Verfahren gemäß Anspruch 1 oder 2 durchzuführen.

**Claims**

1. A method for arithmetically encoding a symbol to be encoded having a binary state based on a current interval width R and a probability representing a probability estimation for the symbol to be encoded, wherein the probability $P_{LPS}$ of the less probable symbol is represented by a probability index for addressing a probability state from a plurality of $N_{max}$ representative probability states $P_n$, wherein the method comprises the following step:

   encoding the symbol to be encoded by performing the following substeps:

   mapping the current interval width to a quantization index from a plurality of K representative quantization indices associated to representative interval widths $Q_k$; and
   performing the interval separation by accessing an interval division table consisting of $K*N_{max}$ product values $Q_k*P_n$ using the quantization index and the probability index to obtain a partial interval width value.

2. A method for arithmetically decoding an encoded symbol having a binary state based on a current interval width R and a probability representing a probability estimation for the encoded symbol, wherein the probability $P_{LPS}$ of the less probable symbol is represented by a probability index of a probability state from a plurality of $N_{max}$ representative probability states $P_n$, wherein the method comprises the following step:

   decoding the encoded symbol by performing the following substeps:

   mapping the current interval width to a quantization index from a plurality of K = 2...8 representative quantization indices associated to representative interval widths $Q_k$; and
   performing the interval division by accessing an interval division table consisting of $K*N_{max}$ product values $Q_k*P_n$ using the quantization index and the probability index to obtain a partial interval width value.

3. The method of claim 2, wherein the decoding further takes place by means of the following step:

   updating the current interval width using the partial interval width value to obtain a new, updated interval width.

4. The method of one of claims 2 to 3, wherein updating the current interval width is further performed depending on a value within a new partial interval **characterized by** the current partial interval width and the value within a new partial interval.

5. The method of claim 4, wherein the decoding is further performed by means of the following substep:

   equating the binary state of the encoded symbol with one of a less probable and a more probable state depending on whether the value within the new partial interval is larger than or equal to, or smaller than a difference of the value of the current interval width and the partial interval width value.

6. The method of one of claims 4 or 5, wherein the encoding is further performed by means of updating the value within the new partial interval with a next bit to be read in.

7. The method of one of claims 4 to 6, further comprising the following step:

   updating the probability estimation, wherein updating the probability estimation comprises looking up, with the probability index, in an LPS transition rule table (Next_State_LPS) to obtain a new probability index, when the value within the new partial interval is larger than or equal to a difference of the value of the current interval width and the partial interval width value, and looking up, with the probability index, in an MPS transition rule table (Next_State_MPS) to obtain a new probability index, when the value within the new partial interval is smaller than a difference of the value of the current interval width and the partial interval width value.

**8.** The method of one of claims 4 to 7, further comprising adjusting a value indicative of the more probable state of the encoded symbol from a state originally indicated to a different binary state, when the probability index is like a predetermined probability index and the value within the new partial interval is larger than or equal to a difference of the value of the current interval width and the partial interval width value.

**9.** The method of one of the preceding claims, wherein the current interval width is represented with an accuracy of b bits, and the partial interval width value obtained from the interval division table is represented with an accuracy of b-2 bits.

**10.** A computer program which enables a computer after it has been loaded into the storage of the computer to perform a method according to claim 1 or 2.

**11.** A computer-readable storage medium on which a program is stored which enables a computer after it has been loaded into the storage of the computer to perform a method according to claim 1 or 2.

**Revendications**

**1.** Procédé de codage arithmétique d'un symbole à coder avec un état binaire sur base d'une largeur d'intervalle actuelle $R$ et d'une probabilité représentant une estimation de probabilité du symbole à coder, la probabilité $P_{LPS}$ du symbole moins probable étant représentée par un indice de probabilité pour l'adressage d'un état de probabilité parmi une pluralité de $N_{max}$ états de probabilité $P_n$ représentatifs, le procédé présentant l'étape suivante consistant à:

coder le symbole à coder en réalisant les étapes partielles suivantes consistant à:

reproduire la largeur d'intervalle actuelle sur un indice de quantification parmi une pluralité de K indices de quantification représentatifs associés à des largeurs d'intervalle $Q_k$ représentatives; et effectuer la subdivision d'intervalle en accédant à l'aide de l'indice de quantification et de l'indice de probabilité à un tableau de division d'intervalle composé de $K*N_{max}$ valeurs de produit $Q_k \times P_n$, pour obtenir une valeur de largeur d'intervalle partielle.

**2.** Procédé de décodage arithmétique d'un symbole codé avec un état binaire sur base d'une largeur d'intervalle actuelle $R$ et d'une probabilité représentant une estimation de probabilité du symbole codé, la probabilité $P_{LPS}$ du symbole moins probable étant représentée par un indice de probabilité d'un état de probabilité parmi une pluralité de $N_{max}$ états de probabilité $P_n$ représentatifs, le procédé présentant l'étape suivante consistant à:

décoder le symbole codé en réalisant les étapes partielles suivantes consistant à:

reproduire la largeur d'intervalle actuelle sur un indice de quantification parmi une pluralité de K = 2 ... 8 indices de quantification représentatifs associés à des largeurs d'intervalle $Q_k$ représentatives; et effectuer la subdivision d'intervalle en accédant à l'aide de l'indice de quantification et de l'indice de probabilité à un tableau de division d'intervalle composé de $K*N_{max}$ valeurs de produit $Q_k \times P_n$, pour obtenir une valeur de largeur d'intervalle partielle.

**3.** Procédé selon la revendication 2, dans lequel le décodage a lieu par ailleurs à l'aide de l'étape suivante consistant à:

mettre à jour la largeur d'intervalle actuelle à l'aide de la valeur de largeur d'intervalle partielle, pour obtenir une nouvelle largeur d'intervalle mise à jour.

**4.** Procédé selon l'une des revendications 2 à 3, dans lequel la mise à jour de la largeur d'intervalle actuelle est par ailleurs réalisée en fonction d'une valeur située à l'intérieur d'un nouvel intervalle partiel **caractérisé par** la largeur d'intervalle partielle actuelle et la valeur située à l'intérieur d'un nouvel intervalle partiel.

**5.** Procédé selon la revendication 4, dans lequel le décodage est réalisé par ailleurs à l'aide de l'étape partielle suivante consistant à:

égaliser l'état binaire du symbole codé avec un état moins probable ou un état plus probable en fonction de si la valeur située à l'intérieur du nouvel intervalle partiel est supérieure ou égale, ou inférieure à une différence entre la valeur de la largeur d'intervalle actuelle et la valeur de largeur d'intervalle partielle.

6. Procédé selon l'une des revendications 4 à 5, dans lequel le décodage est réalisé par ailleurs à l'aide d'une mise à jour de la valeur située à l'intérieur du nouvel intervalle partiel avec un bit à lire suivant.

7. Procédé selon l'une des revendications 4 à 6, présentant par ailleurs l'étape suivante consistant à:

mettre à jour l'estimation de probabilité, la mise à jour de l'estimation de probabilité présentant la consultation, avec l'indice de probabilité, d'un tableau de règles de transition LPS (Next_State_LPS), pour obtenir un nouvel indice de probabilité lorsque la valeur située à l'intérieur du nouvel intervalle partiel est supérieure ou égale à une différence entre la valeur de la largeur d'intervalle actuelle et la valeur de largeur d'intervalle partielle, et la consultation, avec l'indice de la probabilité, d'un tableau de règles de transition MPS (Next_State_MPS), pour obtenir un nouvel indice de probabilité lorsque la valeur située à l'intérieur du nouvel intervalle partiel est inférieure à une différence entre la valeur de la largeur d'intervalle actuelle et la valeur de largeur d'intervalle partielle.

8. Procédé selon l'une des revendications 4 à 7, présentant par ailleurs la conversion d'une valeur indiquant l'état plus probable du symbole codé d'un état affiché initialement à un état binaire différent lorsque l'indice de probabilité est égal à un indice de probabilité prédéterminé et que la valeur située à l'intérieur du nouvel intervalle partiel est supérieure ou égale à une différence entre la largeur d'intervalle actuelle et la valeur de largeur d'intervalle partielle.

9. Procédé selon l'une des revendications précédentes, dans lequel la largeur d'intervalle actuelle est représentée avec une précision de b bits et la valeur de largeur d'intervalle partiel obtenue du tableau de division d'intervalle est représentée avec une précision de b-2 bits.

10. Programme d'ordinateur permettant à un ordinateur, après qu'il ait été chargé dans la mémoire de l'ordinateur, de réaliser un procédé selon la revendication 1 ou 2.

11. Support de mémoire lisible par ordinateur sur lequel est mémorisé un programme qui permet à un ordinateur, après qu'il ait été charge dans la mémoire de l'ordinateur, de réaliser un procédé selon la revendication 1 ou 2.

```
1. Bestimmung des LPS
2. Berechnung der Größen R_LPS und R_MPS:
   R_LPS = R x P_LPS
   R_MPS = R - R_LPS
3. Berechnung des neuen Teilintervalls:
   if (bit = LPS) then
           L ← L + R_MPS
           R ← R_LPS
   else
           R ← R_MPS
4. Aktualisierung der Wahrscheinlichkeitsschätzung P_LPS
5. Ausgabe von Bits und Renormalisierung von R
```

## Fig. 1

```
1. Bestimmung des LPS
2. Quantisierung von R:
   q_index = Qtab[R>>q]
3. Bestimmung von R_LPS und R_MPS:
   R_LPS = Rtab[q_index,p_state]
   R_MPS = R - R_LPS
4. Berechnung des neuen Teilintervalls:
   if (bit = LPS) then
           L ← L + R_MPS
           R ← R_LPS
           p_state ← Next_State_LPS[p_state]
   else
           R ← R_MPS
           p_state ← Next_State_MPS[p_state]
```

## Fig. 2

1. Bestimmung des LPS
2. Quantisierung von R:
   q_index = Qtab[R>>q]
3. Bestimmung von $R_{LPS}$ und $R_{MPS}$:
   $R_{LPS}$ = Rtab[q_index,p_state]
   $R_{MPS}$ = R - $R_{LPS}$
4. Bestimmung von bit, je nach Lage des
   Teilintervalls:
   if (V ≥ $R_{MPS}$) then
           bit ← LPS
           V ← V - $R_{MPS}$
           R ← $R_{LPS}$
           p_state ← Next_State_LPS[p_state]
   else
           bit ← MPS
           R ← $R_{MPS}$
           p_state ← Next_State_MPS[p_state]
5. Renormalisierung von R, Auslesen eines Bits
   und Aktualisierung von V

Fig. 3

```
Enkoder:

    1. Berechnung des neuen Teilintervalls:
       R ← R >> 1
       if (bit = 1) then
            L ← L + R
    2. Ausgabe von Bits und Renormalisierung von R

Dekoder:

    1. Bestimmung von bit, je nach Lage des
       Teilintervalls:
       if (V ≥ R) then
            bit ← 1
            V ← V - R
       else
            bit ← 0
    2. Auslesen eines Bits, Renormalisierung von R und
       Aktualisierung von V
```

Fig. 4

```
Enkoder:

  1. Berechnung des neuen Teilintervalls:
     L ← L << 1
     if (bit = 1) then
          L ← L + R


  2. Ausgabe eines Bits und Renormalisierung mit
     verdoppelten Entscheidungsschwellwerten(ohne
     Verdoppelung von R und L)

Dekoder:

  1. Auslesen eines Bits und Aktualisierung von V
  2. Bestimmung von bit, je nach Lage des
     Teilintervalls:
     if (V ≥ R) then
          bit ← 1
          V ← V - R
     else
          bit ← 0
```

Figur 5

```
  1. preState = min(max( 1,((m * SliceQP )>>4)+n),126)
  2. if (preState <= 63) then
          p_state = 63 - preState
          valMPS = 0
     else
          p_state = preState - 64
          valMPS = 1
```

Figur 6

**EP 2 326 013 B1**

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- US 5592162 A

**In der Beschreibung aufgeführte Nicht-Patentliteratur**

- **T. WIEGAND ; G. SULLIVAN.** *Draft Text of Final Draft International Standard (FDIS) of Joint Video Specification (ITU-T Rec. H.264 | ISO/IEC 14496-10 AVC),* Marz 2003
- **D. A. HUFFMAN.** A Method for Construction of Minimum Redundancy code. *Proc. IRE,* 1952, vol. 40, 1098-1101
- **I. H. WITTEN ; R. M. NEAL ; J. G. CLEARY.** Arithmetic Coding for Data Compression. *Communication of the ACM,* 1987, vol. 30 (6), 520-540
- **G. G. LANGDON ; J. RISSANEN.** A Simple General Binary Source code. *IEEE Transactions on Information Theory,* 1982, vol. 28, 800-803
- **C. E. SHANNON.** A Mathematical Theory of Communication. *Bell Syst. Tech. Journal,* 1948, vol. 27, 379-423623-656
- Information Theory and Coding. **P. ELIAS.** Information Theory and Coding. Mc-Gra-Hill, 1963
- **J. RISSANEN.** Generalized Kraft Inequality and Arithmetic Coding. *IBM J. Res. Develop.,* 1976, vol. 20, 198-203
- **R. C. PASCO.** Source Coding and Algorithms for Fast Data Compression. *Ph. D. Dissertation, Stanford University, USA,* 1976
- **G. G. LANGDON.** An Introduction to Arithmetic Coding. *IBM J. Res. Develop.,* 1984, vol. 28, 135-149
- **A. MOFFAT ; R. M. NEAL ; I. H. WITTEN.** Arithmetic Coding Revisited. *Proc. IEEE Data Compression Conference, Snowbird (USA,* 1996, 202-211
- **J. RISSANEN ; K. M. MOHIUDDIN.** A Multiplication-Free Multialphabet Arithmetic Arithmetic Code. *IEEE Trans. on Communication,* 1989, vol. 37, 93-98
- **W. B. PENNEBAKER ; J. L. MITCHELL ; G. G. LANGDON ; R. B. ARPS.** An Overview of the Basic Principles of the Q-Coder Adaptive Binary Arithmetic Coder. *IBM J. Res. Develop.,* 1988, vol. 32, 717-726
- **P. G. HOWARD ; J. S. VITTER.** Practical Implementations of Arithmetic Coding'', in ''Image and Text Compression. Kluwer, 1992
- **L. HUYNH ; A. MOFFAT.** A Probability-Ratio Approach to Approximate Binary Arithmetic Coding. *IEEE Trans. on Information Theory,* 1997, vol. 43, 1658-1662
- **D. CHEVION ; E. D. KARNIN ; E. WALACH.** High-Efficiency, Multiplication Free Approximation of Arithmetic Coding. *Proc. IEEE Data Compression Conferenc, Snowbird (USA,* 1991, 43-52
- **G. FEYGIN ; P. G. GULAK ; P. CHOW.** Minimizing Excess Code Length and VLSI Complexity in the Multiplication Free Approximation of Arithmetic Coding. *Inform. Proc. Manag.,* 1994, vol. 30, 805-816
- **D. L. DUTTWEILER ; CH. CHAMZAS.** Probability Estimation in Arithmetic and Adaptive-Huffman Entropy Coders. *IEEE Trans. on Image Processing,* 1995, vol. 4, 237-246